Europäisches Patentamt

European Patent Office

Office européen des brevets

(19)

(11) Publication number: **0 048 478**
**B1**

(12) **EUROPEAN PATENT SPECIFICATION**

(45) Date of publication of patent specification: **18.04.84**

(21) Application number: **81107459.0**

(22) Date of filing: **19.09.81**

(51) Int. Cl.³: **G 03 C 1/68, G 03 C 1/72, G 03 C 1/727, G 03 C 5/04, G 03 C 5/36, G 03 C 11/20, C 08 J 7/04 // G03C11/12**

(54) Process for modifying tacky surfaces.

(30) Priority: **23.09.80 US 189829**
**23.09.80 US 189828**

(43) Date of publication of application:
**31.03.82 Bulletin 82/13**

(45) Publication of the grant of the patent:
**18.04.84 Bulletin 84/16**

(84) Designated Contracting States:
**BE DE FR GB NL**

(56) References cited:
**None**

(73) Proprietor: **E.I. DU PONT DE NEMOURS AND COMPANY**
**Legal Department 1007 Market Street**
**Wilmington Delaware 19898 (US)**

(72) Inventor: **Charles, Magalie Marie**
**93 Norwood Avenue**
**Staten Island New York 10304 (US)**
Inventor: **Romano, Albert Peter**
**Broadway & Lambs Road**
**Pitman New Jersey 08071 (US)**
Inventor: **Heiart, Robert Bernard**
**6 Arthur Place**
**Middletown New Jersey 07748 (US)**

(74) Representative: **Werner, Hans-Karsten, Dr. et al,**
**Deichmannhaus am Hauptbahnhof**
**D-5000 Köln 1 (DE)**

# O O48 478

## Process for modifying tacky surfaces

### Technical Field

This invention relates to a process for modifying a tacky surface. More particularly, this invention relates to the use of an admixture of particulate material and carrier particles to modify the tacky surface.

### Background Art

Items or objects that people use or see in their daily lives range in appearance from high gloss to dull or flat. Highly glossy surfaces reflect a high proportion of the light directed at them specularly. In many instances it is desirable to modify light reflectivity to reduce high gloss or change other properties. For example, it is particularly desirable in the photoimaging and image reproduction industry to modify the light reflectivity of photosensitive materials which are useful as color proofs. The modification of the light reflectivity of the outer surface of a color proof results in a matte finish. Photosensitive materials used in colorproofing are of the positive- or negative-working types. A positive-working process is described in Chu and Cohen U.S.—A— 3,649,268. Positive-working materials contain tacky photohardenable compositions which when exposed imagewise to actinic radiation harden in the exposed image areas resulting in tacky and complementary nontacky image areas. The image areas which remain tacky can be developed by applying colored powders such as toners and pigments. A negative-working process is described in Cohen and Fan U.S.—A— 4,174,216. Negative-working elements useful in the negative-working process comprise a support, a tacky, nonphotosensitive contiguous layer, a photohardenable photoadherent layer and a strippable cover sheet. After imagewise exposure to actinic radiation the cover sheet is peeled away together with the exposed areas of the photoadherent layer revealing the tacky contiguous layer beneath. The photoadherent layer in the unexposed image areas remains as a resist over the complementary portions of the contiguous layer. The tack contiguous layer revealed in the exposed image areas is then toned with pigment. Layers toned with different pigments can be applied in registration over one another to form multilayer suprint color proofs. Dependent on the thickness of the layers, the proof may exhibit a pronounced undesirable three-dimensional effect. The multilayer surprint proofs having a positive-working photosensitive outer layer upon ageing exhibit cracks or crazes in the surface thereof.

Many methods have been used to provide the positive-working materials and/or negative-working materials with matte finishes. Such methods include wet as well as dry systems, the latter being particularly desirable. Particulate materials of the oil-absorbing type have been applied to positive-working systems.

It is desired that a method be provided whereby the degree of matte of a tacky surface can be effectively controlled and the three-dimensional effect eliminated, when present, by a dry process which does not require but can utilize a pre-exposure step, e.g., through a halftone screen, particularly when the surface of a surprint proof is modified. Desirably the method can use a variety of particulate materials, not being restricted to the use of oil-absorbing particulate materials.

### Disclosure of Invention

In accordance with this invention there is provided in a process for modifying a tacky surface by adhering particulate material thereto which comprises

(1) applying the particulate material to said tacky surface, and

(2) removing excess particulate material therefrom,

the improvement wherein prior to application to the tacky surface the particulate material is admixed with carrier particles which are removed with the excess particulate material, the ratio of the average particle diameter of carrier particles to that of the particulate material in the mixture being greater than 2 and the weight ratio of particulate material to carrier particles being less than 1.

Also in accordance with this invention there is provided in a process for modifying a tacky surface of a surprint multicolor proof having at least two nonplanar, nonsilver halide, negative-working colored photoimaged elements sequentially bonded to a support, and a photosensitive tacky layer present as the outer layer of the proof which comprises

(1) applying to the tacky surface an admixture of particulate material and carrier particles, the ratio in the admixture of the average particle diameter of carrier particles to that of the particulate material in the admixture being greater than 2 and the weight ratio of particulate material to carrier particles being less than 1, and

(2) removing excess particulate material and the carrier particles from the tacky surface, the improvement wherein prior to application to the tacky surface of the admixture of particulate material and carrier particles the photosensitive tacky layer is exposed through a screen tint.

In practicing the process of the invention many types of tacky surfaces can be modified by applying the admixture of particulate material and carrier particles. Tacky layers, for example, may be applied over painted surfaces which may have decorations present thereon; pictures, photographs and tacky photosensitive or nonphotosensitive layers, some types of which are illustrated in the examples below. When the surfaces are not tacky per se they may be made tacky by the application of adhesive

2

O 048 478

materials, e.g., in spray or liquid form. Also useful for tacky layers are materials which have been temporarily plasticized, e.g., wet gelatin and wet polyvinyl alcohol, which are particularly useful on photographic prints. Specific glossy surfaces which are not tacky in their natural state and to which the tacky layers can be applied include metal, e.g., aluminum, steel, etc.; plastic, e.g., polyethylene terephthalate, polyvinyl acetate, polyamide, etc.; paper; wallboard; wood; etc.

Preferred surfaces to which the admixture of particulate material and carrier particles are applied are formed from positive-working photohardenable elements as described in U.S.—A— 3,649,268 and negative-working photopolymer elements described in U.S.—A— 4,174,216. The positive-working photohardenable elements comprise (1) a removable support, (2) a photohardenable or photopolymer layer containing at least one free radical initiated, chain propagating, addition polymerizable compound containing at least one terminal ethylenic group, and an addition polymerization initiator activatable by actinic radiation, and optionally a compatible macromolecular organic polymeric binder, and (3) a strippable cover sheet. The negative-working elements comprise, in order from top to bottom, (1) a strippable cover sheet, (2) a photoadherent layer comprising a material with ethylenically unsaturated or benzophenone type groups, which is generally nontacky, (3) a tonable organic contiguous layer, e.g., a tacky, nonphotosensitive elastomeric layer which is tonable by application of particulate material, and optionally (4) a sheet support.

The positive-working and negative-working elements can be used to form surprint elements. Surprint elements are elements wherein at least two photosensitive elements that have been imaged and colored with different colorants (nonplanar, nonsilver halide colored, photoimaged elements) are sequentially laminated or bonded to a suitable support surface, e.g., paper, film, etc. In forming a surprint element, the cover sheet and any sheet support present in the photosensitive elements are removed. Generally a negative-working or positive-working photosensitive element is applied to the outermost colored photoimaged element of the surprint element. When the outer element of the surprint is a negative-working element, it is uniformly or nonimagewise exposed, the cover sheet present is removed together with the exposed adherent photosensitive layer, leaving a tacky, nonphotosensitive layer on the surprint. The tacky layer is then treated with particulate material according to the invention.

Generally, the surprint element has over its support four imaged colored photopolymer elements, e.g., yellow, magenta, cyan, black, and an optional fifth nonimaged photopolymer element. A multicolor suprint element prepared by the surprint method is described in U.S.—A— 3,649,268 and 4,174,216. Colorants and toners used in preparing the surprints are described in U.S.—A— 3,620,726, 3,909,326 and Manger et al., U.S.—A— 4,304,843.

After the negative-working multicolor surprint proof with the positive-working photohardenable element present thereon is prepared, the surprint proof is exposed through a screen tint as described more fully below, the protective film of the exposed positive-working element is removed and an admixture of particulate material and carrier particles is applied to the exposed tacky surface.

The carrier particles are generally transparent or translucent, inert, i.e., nonelectroscopic, spheroidal-shaped solid polymer particles with an average diameter of from about 10 to 100 $\mu$m. The particle size can be measured, for example, by a Coulter Counter, Coulter Electronics, Inc., Hialeah, Florida. The selection of the size of the carrier particles is determined by certain factors. For example, the carrier particles must be large enough to be readily removed from the tacky surface to which they are applied. Conversely, the carrier particles must be small enough so that, together with attached particulate material, the inert carrier particles can be uniformly wiped over the tacky surface. Useful carrier particles include: polymethylmethacrylate, polyethylemethacrylate, polyethylene, polyvinyl chloride, polyvinyl acetate, polystyrene, polyvinyl alcohol, cellulose acetate, and preferably ionic copolymer of $\alpha$-olefins having the formula $R - CH = CH_2$ where R is a radical selected from the class consisting of hydrogen, alkyl of 1 to 8 carbon atoms and $\alpha,\beta$-ethylenically unsaturated carboxylic acid having from 3 to 8 carbon atoms, the copolymers having from 10% to 90% of the carboxylic acid groups ionized by neutralization with metal ions uniformly distributed throughout the copolymer.

Admixed with the carrier particles are particulate materials having an average diameter of from 1 to 20 $\mu$m, the ratio of the average diameter of the carrier particles to that of the particulate material being greater than 2 to 1. The size of these particles can also be measured by a Coulter Counter. A useful range of average diameter carrier particles to particulate material is between 2:1 to 30:1. The amount by weight of particulate material in the admixture is also important. The weight ratio of particulate material to carrier particles is less than 1:1. A percent range is between about 0.1 to 50% by weight particulate material to 50 to 99.9% by weight carrier particles. As the ratio of particulate material to carrier particles changes, the degree of matte is altered as noted below. Useful substantially colorless particulate materials, alone or in combination, include: cellulose acetate, polyvinyl alcohol, polyethylene resins, waxes, diatomaceous silica, starches, e.g., rice and corn; talc, etc.; and colored pigments or toners such as those described in U.S.—A— 3,620,726; 3,909,326 and Manger et al. U.S.—A— 4,304,843, in combination with the substantially colorless particulate materials. The pigments can be present in an amount 0 to 20% by weight based on the weight of admixture to tint the tacky surface. While, surprisingly, the particulate material and carrier particles can be similar in composition, the ratios of average diameter and weight set forth above must be observed.

3

**0 048 478**

In practicing the process of this invention, a carrier particle of average diameter suitable for the tacky surface which is to be modified is selected and is mixed with a pre-determined amount of particulate material. The amount of gloss can be determined for various admixtures of particulate material and carrier particles. Various percentage amounts of cellulose acetate particulate material (5 $\mu$m average diameter) and Surlyn®A ionomer resin (25 $\mu$m average diameter) are applied to the surface of a layer of photopolymer present on a four-color proof prepared as described in Example 1 below. The admixture can be applied to the tacky surface by use of a fiber pad dipped into the admixture and wiped over the tacky surface or by an applicator such as described in Sandner U.S.—A—4,019,821. The "glossiness" of the treated surface is plotted in gloss units determined by means of a Photoelectric Glossmeter, Model 610, Photovolt Corp., 1115 Broadway, New York, New York. High gloss (no matte) is achieved with substantially no particulate cellulose acetate present. The lowest amount of gloss (high matte) is achieved at a level of less than 50% by weight particulate cellulose acetate in the admixture. By selecting an amount of particulate cellulose acetate in the admixture intermediate between the aforementioned amounts, the operator can modify the tacky surface to any degree of matte that is desired. Optionally, prior to the application of the admixture to the tacky surface, the photopolymer surface can be exposed through a removable protective sheet, through a superimposed halftone screen tint, followed by removal of the protective sheet, when present. The exposure and the screen can be varied to adjust the polymerization of the surface and consequently the level of matte. Not only can the tacky surface be given a matte finish, but the surface can also be tinted by adding to the admixture a small amount of a particulate colored pigment or toner as described above. Generally in tinting the components of the admixture other than the pigment or toner are colorless or translucent. Subsequent to the application of the admixture to the tacky photopolymer surface and removal of excess particulate material, if necessary, the surface may be exposed to actinic radiation to harden the surface. The exposure can be by various sources rich in ultraviolet radiation known to those skilled in the art, e.g., Berkey-Ascor Vacuum Printer, mercury vapor lamps, pulsed xenon lamps, etc., generally for a period of 10 seconds or more.

Screen tints which can be used to control exposure of the tacky surface are those which have a tint value (positive percent dot area) of 25 to 75 percent with a ruling corresponding to 85 lines to 400 lines per inch (33.46 to 157.5 lines per cm), preferaby 225 to 325 lines per inch (88.58 to 127.95 lines per cm). Preferred screen tints are those with a random photographic pattern, referred to in the trade as a "grained" or "mezzotint". Also useful are standard ruled tints (halftone screen tints).

### Best Mode for Carrying Out the Invention

The best mode is illustrated in Example 2 wherein a four-color negative colour proof having a fifth, clear photopolymer layer laminated thereover is treated with an admixture of 10% by weight cellulose acetate (5 $\mu$m average diameter) and 90% by weight ionic copolymer (25 $\mu$m average diameter) to achieve a nonglossy matte finish free from three-dimensional effects and useful as a surprint proof which simulates a press proof. In Example 20 exposure through a screen tint is disclosed.

### Industrial Applicability

The process of the invention is useful in modifying the glossiness of a variety of tacky surfaces. The tacky surfaces may be otherwise nontacky, nonphotosensitive ones such as painted or decorated walls or surfaces of metal or plastic, plastic film materials, etc. to which a tacky material has been applied; or tacky non-photosensitive layers such as tacky, elastomeric surfaces, or photosensitive layers such as photopolymer layers. The process is particularly useful in modifying the tacky surfaces of color proofs of the negative- or positive-working types. The treated surface of the color proof has a matte finish which is free from undesirable three-dimensional effects. The color proof containing the matte-finish, the degree of which can be controlled by the process, is suitable as a surprint proof to simulate a press proof. The tacky treated surface of the surprint proof, which may be exposed through a screen tint and particulate material/carrier particles mixture applied thereto, has a matte finish, the degree of which can be controlled by the process. The matte surface is durable and nonblocking and is capable of being written on by writing devices such as pencil, pen and crayon. In addition, the resistance to cracking or crazing of the surprint proof is surprisingly lengthened. This is particularly important since surprint proofs are normally retained for extended periods of time, e.g., 2 to 3 months and longer. Without the exposure through the screen tint untreated proofs have been known to crack and craze within 2 to 3 weeks. The multilayer surprint proof is free from the three-dimensional effect and closely simulates a press proof.

4

Examples
The following examples illustrate the invention wherein the parts and percentages are by weight.

Example 1
A photopolymerizable composition is prepared by mixing together the following ingredients:

| Ingredient | Amount (parts) |
| --- | --- |
| Polymethylmethacrylate, molecular weight 30,000, density 1.13 g/ml | 32.40 |
| Trimethylolpropane trimethacrylate | 35.60 |
| 2-o-Chlorophenyl-4,5-bis-(m-methoxy-phenyl) imidazolyl dimer | 1.58 |
| 2-Mercaptobenzothiazole | 0.79 |
| Polyoxyethylene lauryl ether | 7.90 |

The mixture is dissolved in methylene chloride (20% solution) and is coated onto a 0.001 inch (.0025 cm) thick polyethylene terephthalate support and a 0.001 inch (0.0025 cm) thick cover sheet of polypropylene is laminated onto the coating at room temperature. The cover sheet is removed at room temperature with substantially no effect on the photopolymerizable layer, and the layer is laminated at about 110°C to the smooth side of Kromekote® cast-coated one-side paper, manufactured by Champion Paper and Fiber Company on a fixed-bed transfer machine as described in Chu et al. U.S.—A—3,594,535. The photopolymer layer is exposed at a distance of about 27 inches (68.6 cm) through a minus-blue separation halftone positive for about 8 seconds using a nuArc® Plate Maker "Flip Top", Model FT26M—2 carbon arc light source. The polyethylene terephthalate support is removed at room temperature and Dalamar® yellow toner (Pigment yellow 74 C.I. #11741) prepared according to Example 9 of Manger et al., U.S. Patent 4,215,193 is applied to the photopolymer surface. Excess toner is removed with a cotton pad. The toner adheres only to those areas that were not exposed to the radiation.

The cover sheet is removed from a second element coated with the above-described composition, and the clear photopolymer layer is laminated onto the yellow-toned layer, obtained above, at a temperature of 110°C. The two-layer film base is exposed through a minus-green separation halftone positive for 3 seconds using the nuArc® light source. The base support is stripped from the photopolymer, and a magenta toner, a dispersion consisting of 50 percent mixture of quinacridone magenta, Quindo Magenta (C.I. Pigment Red 122) and Indo Brilliant Scarlett toner (Pigment Red 123, C.I. #71145) and 50 percent cellulose acetate, prepared as described in Example 11 of U.S.—A—4,215,193, is applied to the exposed surface at room temperature. The excess toner is dusted off with a cotton pad, the pigment adhering to the underexposed areas only.

The cover sheet is removed from a third photopolymerizable element coated with the above-described composition and the clear photopolymer layer is laminated onto the magenta-toned layer, obtained above, at a temperature of 110°C. This is exposed through the minus-red halftone positive for 3 seconds using the nuArc® light source. The polyethylene terephthalate support is removed from the layer, and a phthalocyanine cyan toner, a dispersion of 50 percent mixture of Monastral® Blue G (Copper Phthalocyanine Pigment Blue 15, C.I. #74160) and Monastral® Green G (Pigment Green 7, C.I. #74260) and 50 percent cellulose acetate prepared as described in Example 1 of U.S.—A—4,215,193 is dusted onto the exposed surface at room temperature. The excess toner is removed with a cotton pad, leaving pigment in the underexposed areas only.

A fourth photopolymerizable layer is laminated onto the cyan-toned layer of the three-layer film base using the same procedure and under the same conditions used in preparing the two previous layers. The fourth layer is exposed through a black printer halftone positive for 3 seconds using the nuArc® light source. After stripping off the polyethylene terephthalate support, a carbon black toner, Carbon Black, Sterling® NS N774 (C.I. Pigment Black 7, C.I. #77266) prepared as described in Example 10 of U.S.—A—4,215,193, predispersed in pentaerythritol resin is applied to the exposed surface at room temperature. The excess pigment is dusted off with a cotton pad, leaving pigment in the underexposed areas only.

After application of the black toner to the photopolymerizable layer, a fifth layer of photopolymer is laminated at 110°C over the four-color halftone positive which exhibits a slight three-dimensional effect. The polyethylene terephthalate support is removed after the lamination. A mixture of particulate cellulose acetate (1 g, about 5 μm average diameter) and Surlyn®A ionomer resin beads manu-

# 0 048 478

factured by E.I. du Pont de Nemours and Company, Wilmington, Delaware (20 g, about 25 $\mu$m average diameter) is applied by means of a fiber pad dipped into the admixture to the unexposed tacky photopolymer surface, and the surface is wiped with a cotton cloth to remove excess cellulose acetate and all the carrier particles. The four-color proof has a uniform matte appearance, a hard dry surface and simulates closely a press proof.

## Example 2
A negative-working pre-press color proof of the surprint type is prepared as follows:

### I. Nontonable Photopolymerizable Layer
A coating solution of a photopolymerizable composition is prepared by mixing together the following ingredients:

| Ingredient | Weight (g) |
| --- | --- |
| Polymethyl methacrylate (MW 200,000—300,000) | 41.54 |
| Di-(3-acryloxy-2-hydroxypropyl) ether of Bisphenol-A | 51.86 |
| (2-Chlorophenyl-4,5-diphenyl imidazolyl) dimer | 2.20 |
| 2-(Stilbyl-4'')-(naptho-1',2';4,5) 1,2,3-triazol-2''-sulfonic acid phenyl ester | 2.20 |
| 2-Mercaptobenzoxazole | 1.50 |
| Polyethylene oxide (MW 600,000) | 0.70 |
| Methanol | 20.70 |
| Methylene chloride | 323.70 |

This solution is coated at a coating weight of about 40 mg/dm$^2$ when dried on a clear polyethylene terephthalate film having a thickness of 0.0005 inch (0.0015 cm) which is surface treated by electrostatic discharge at 0.07 (coulombs/ft$^2$ (0.093 coulombs/m$^2$).

### II. Tonable, Tacky Elastomer Contiguous Layer
A coating solution is prepared by mixing together the following ingredients:

| Ingredient | Weight (g) |
| --- | --- |
| Random copolymer of styrene/butadiene (40/60) | 19.75 |
| Cis-polybutadiene (Mooney Viscosity 55—60) | 79.75 |
| Tetra-bis-[methane 3-(3',5'-di-t-butyl-4'-hydroxyphenyl) proprionate] methane | 0.50 |
| Methylene chloride to make | 1333.30 |

This solution is coated on polyethylene terephthalate film having a releasable layer of polydimethyl siloxane coated thereon to give a coating weight of about 125 mg/dm$^2$ when dried.

### III. Laminating Procedure
The supported photopolymerizable layer (I) and the supported tonable, tacky elastomer contiguous layer (II) are laminated in surface-to-surface relationship at room temperature with a pressure of about 40 psi (275790,4 Pa)

6

IV. Operations for Preparation of a Surprint

The laminate (III) is further handled as follows:

The polyethylene terephthalate film with the siloxane release coating is stripped from the tonable, tacky layer and the resulting element is then laminated at 100°C to a 0.012 inch (0.03 cm) thick paper support (identified as Baryta® Paper, marketed by the Intermill Corporation, Belgium). The element is then exposed to a halftone negative, minus-blue, color separation film record, the exposure being made through the electrostatic discharge treated, clear polyethylene terephthalate film. This exposure is about 30 seconds on an exposing device identified as a Berkey-Ascor Vacuum Printer, fitted with a photopolymer lamp (2 KW) and a Kokomo® glass filter (No. 400) Kokomo Opalescent Glass Co., Kokomo, IN. The distance between the lamp and the vacuum frame of this device is about 38 inches (96.52 cm). After the exposure is made, the exposed element is taped securely to a suitable flat surface, and the clear polyethylene terephthalate film cover sheet is stripped by pulling at one corner with an even, continuous motion at an angle of about 135—180°. The resulting exposed, photopolymerized image photoadheres to the electrostatic discharge treated film and is removed with the film thus exposing equivalent areas of the tacky, elastomer contiguous layer on the paper support. The bared areas of the contiguous layer are toned using a yellow toner, Dalamar® Yellow (Pigment Yellow 74, C.I. No. 11741). A second laminate (III) having its polyethylene terephthalate film with release coating removed as described above is laminated to the surface of the yellow image and is exposed to a halftone, negative, minus-green color separation film record in registration. The clear, surface treated polyethylene terephthalate film of the second laminate is stripped from the contiguous layer leaving bared an image which is toned with a magenta toner as described above. The process is then repeated for the minus-red (cyan toner) and black negative records. The toners used are described in Example 1 above. This procedure yields a four-color negative surprint proof.

Conventionally the surprint proof is finished by laminating an additional laminate (III) as described above having its polyethylene terephthalate film with release coating stripped therefrom to the outer surface of the four-color proof. The composite element is given an overall exposure with the clear polyethylene terephthalate film cover sheet in place to harden the photopolymerizable layer. The laminate (III) serves to transparentize the upper toned layer of the composite element and by exposure with the cover sheet in place also serves to protect the surprint proof. The image, when viewed through the glossy polyethylene terephthalate film has high gloss, a three-dimensional effect and the image is not as sharp as a press sheet.

In place of laminate (III), onto the outer surface of the four-color proof is laminated at 110°C a positive-working photopolymer layer similar to the fifth layer of photopolymer described in Example 1. An admixture of particulate cellulose acetate (2.0 g, about 5 μm average diameter) and Surlyn®A ionomer resin beads (carrier particles) described in Example 1 (20 g, about 25 μm average diameter) is applied to the unexposed tacky photopolymer after removal of the polyethylene terephthalate film. After removal of the excess particulate cellulose acetate and carrier particles as described in Example 1, the four-color proof has a uniform matte finish which is clean, dry and resembles a press sheet. The three-dimensional effect is eliminated.

Example 3

Eleven (11) four-color positive proofs are prepared as described in Example 1. Each proof has a fifth layer of the unexposed photopolymer laminated over the four-color image as described in Example 1. Various admixtures of the carrier particles (about 25 μm average diameter) and particulate cellulose acetate (about 5 μm average diameter) as described below are applied to the tacky photopolymer surface of the proof. The gloss is read using a photoelectric Glossmeter, Model 610, Photovolt Corp., 1115 Broadway, New York, NY 10010, with the following results:

| Sample | Cellulose Acetate in Admixture (%) | Gloss Units (Avg. 3 runs) |
|---|---|---|
| 1 (control) | none | 96 |
| 2 | 0.1 | 81 |
| 3 | 1.7 | 74 |
| 4 | 2.5 | 67 |
| 5 | 5.0 | 46 |
| 6 | 7.5 | 36 |
| 7 | 10.0 | 55 |
| 8 | 20.0 | 42 |
| 9 | 25.0 | 47 |
| 10 | 30.0 | 39 |
| 11 | 50.0 | 32 |

This example shows that the degree of matte can be controlled by the addition to the tacky photopolymer surface of the four-color proof of various concentration particulate material/carrier particle admixture.

Example 4

Three (3) four-color proofs containing a fifth layer of unexposed photopolymer are prepared as described in Example 1. After removal of the polyethylene terephthalate film, to the tacky photopolymer surface is applied an admixture of polyethylene carrier particles (about 14 $\mu$m average diameter) and particulate cellulose acetate (about 5 $\mu$m average diameter). Each sample is examined on the glossmeter described in Example 3 with the following results:

| Sample | Cellulose Acetate in Admixture (%) | Gloss Units |
|---|---|---|
| 1 (control) | none | 84 |
| 2 | 1.0 | 48 |
| 3 | 10.0 | 28 |

This example illustrates the use of polyethylene as carrier particles in combination with particulate cellulose acetate to control modification of a tacky surface.

Example 5

Two positive four-color proofs are prepared as described in Example 1 and two negative four-color proofs are prepared as described in Example 2. A fifth layer of unexposed photopolymer (Ex. 1) is applied to each of these proofs, and the polyethylene terephthalate film is removed as described in Example 1. To the tacky surface of each sample is applied as described in Example 1 an admixture of polyvinyl alcohol (PVA) carrier particles (about 32 $\mu$m average diameter) and particulate cellulose acetate (about 5 $\mu$m average diameter). Each sample is examined on the glossmeter described in Example 3 with the following results.

8

| Sample | Cellulose Acetate in Admixture (%) | Gloss Units |
|---|---|---|
| Positive (control) | none | 75 |
| Positive | 10.0 | 21 |
| Negative (control) | none | 83 |
| Negative | 10.0 | 15 |

This example illustrates the use of different carrier particles to modify a tacky photopolymer surface over positive-working and negative-working photopolymer four-color proofs.

Examples 6 and 7

Example 5 is repeated using two additional admixtures containing carrier particles and particulate material. The admixtures are as follows:

| Example | Carrier Particles (Average diameter) | Particulate Material (Avg diameter) |
|---|---|---|
| 6 | Cellulose Acetate (27 $\mu$m | Cellulose Acetate (5 $\mu$m) |
| 7 | Surlyn®A Ionomer Resin (See Example 1) (25 $\mu$m) | Diatomaceous Silica (5 $\mu$m) |

About 10 percent of particulate cellulose acetate is present in the admixture of Example 6 and about 10 percent of particulate diatomaceous silica is present in the admixture of Example 7. Each of the admixtures is applied to the tacky surface present on a positive-working color proof and a negative-working color proof. The surfaces of the proofs have a matte finish which closely resembles and matches a press sheet.

Examples 8 to 13

The following carrier particles/particulate material admixtures are applied to the tackyl photopolymer layer over a four-color proof prepared as described in Example 1.

| Example | Carrier Particles (Average diameter) | Particulate Material (Avg diameter) |
|---|---|---|
| 8 | Surlyn®A Ionomer Resin (25 ®m) | Diatomaceous Silica (12 $\mu$m) |
| 9 | Surlyn®A Ionomer Resin (27 $\mu$m) | Rice Starch (14 $\mu$m) |
| 10 | Polymethylmeth-acrylate (55 $\mu$m) | Cellulose Acetate (5 $\mu$m) |
| 11 | Surlyn®A Ionomer Resin (25 $\mu$m) | Polyethylene wax (7 $\mu$m) |
| 12 | Surlyn®A Ionomer Resin (25 $\mu$m) | Talcum Powder (6.7 $\mu$m) |
| 13 | Surlyn®A Ionomer Resin (25 $\mu$m) | Corn Starch (12 $\mu$m) |

The surfaces of the four-color proofs have good matte finishes which match a press sheet.

## Example 14

A four-color proof is made according to Example 2 over the tacky outer photopolymer layer is applied an admixture of particulate cellulose acetate (0.9 g, about 5 $\mu$m average diameter) diluted with yellow toner described in Example 1 (0.1 g, about 2 $\mu$m average diameter) and Surlyn®A ionomer resin (10 g, about 25 $\mu$m average diameter). The admixture contains 99% cellulose acetate and 1% yellow toner. The modified element has a slight yellow tint. The tinting step may be necessary to match certain papers, for example, during the pressproof matching step.

## Examples 15 and 16

Two four-color proofs are made, one according to Example 1 (positive-working) and one according to Example 2 (negative-working). An additional laminate (III) from Example 2 is laminated to elements as described in Example 2 and is given an overall exposure in order to harden the nontonable photopolymer layer (I) which is then removed with the cover sheet exposing the tonable, tacky elastomer contiguous layer (II) over the four-color proof. A mixture of particulate cellulose acetate (1 g, about 5 $\mu$m average diameter) and Surlyn®A ionomer resin beads (20 g, about 25 $\mu$m average diameter) is applied to the tonable, tacky layer as described in Example 1. Control positive and negative color proofs are prepared which contain the tacky layer without addition of particulate material and carrier particles to the surface. The following results are achieved.

| Example | Gloss Units | Appearance |
|---|---|---|
| 15 (positive | 62 | Smooth; good matte |
| 16 (negative) | 55 | Smooth; good matte |
| Control (positive) | 78 | Tacky; no matte |
| Control (negative) | 86 | Tacky; no matte |

This example demonstrates the modification of a nonphotosensitive but tacky surface.

## Example 17

A sample of aluminum foil, No. 672, Reynolds Metal Co., Richmond, VA is coated with rubber cement (Best-Test® Paper Cement, Union Rubber, Inc., Trenton, NJ) using a 2.0 (0.005 cm) doctor knife. While the layer is still tacky, the mixture of cellulose acetate and Surlyn®A ionomer resin beads described in Example 1 is applied thereto with the following results:

| | Gloss Units | |
|---|---|---|
| Foil Uncoated | Coated | Coated and Treated |
| 100 | 90 | 55 |

The surface of the coated and treated aluminum foil is smooth and uniform with a pleasing matte finish and no evidence of carrier particle pickup.

## Example 18

A sample of uncoated, clear 0.007 inch (0.0178 cm) thick polyethylene terephthalate film is coated with a 10% aqueous solution of polyvinyl alcohol using a 2.0 mil (0.005 cm) doctor knife. While this layer is still tacky, the mixture of cellulose acetate and Surlyn®A ionomer resin beads described in Example 1 is applied thereto. The clear, tacky layer turns milky white, and the gloss level is reduced from 96 units to 58 units.

This example, as well as Example 17, demonstrates the use of the process of this invention to modify surfaces containing tacky coatings thereon.

## Example 19

Two, four-color proofs are prepared and a fifth layer of unexposed photopolymer laminated thereover as described in Example 1. After removal of the cover sheet one sample is treated with polyvinyl chloride (PVC) beads (Geon® 99, General Electric Co., average diameter greater than 80), and the second sample is treated with a mixture of cellulose acetate (1 g, about 5 $\mu$m average diameter) and similar polyvinyl chloride beads (20 g) as described above. The following results are obtained.

**O O48 478**

| Sample | Gloss Units | Appearance |
|---|---|---|
| PVC | 83 | Clear-tacky |
| Cellulose acetate/PVC | 58 | Smooth, uniform, matte, dry |

### Controls A and B

Three samples of positive-working four-color proofs are prepared having a tacky outer photopolymer layer as described in Example 1. To the tacky surface of each sample is applied as described in Example 1 an admixture of carrier particles and particulate material as follows:

| Control | Carrier Particles (Average diameter) | Particulate Material (Avg diameter) |
|---|---|---|
| A | Surlyn®A Ionomer Resin (25 $\mu$m) | Polyvinyl Alcohol (32 $\mu$m) |
| B | Cellulose Acetate (27 $\mu$m) | Surlyn®A Ionomer Resin (25 $\mu$m) |

The percent of particulate material present in the admixture of the listed controls is ten. Each sample exhibits high gloss, in the range of 95 gloss units, indicating that substantially no particulate material adheres to the tacky photopolymer surface after wiping with a cotton cloth. These controls illustrate the criticality of the ratio of the average particle diameter of the carrier particles to particulate material.

### Controls C to H

Six four-color proofs are made according to Example 1 and a fifth layer of unexposed photopolymer made according to Example 1 is laminated thereon.
Various mixtures (C to H) of polyethylene beads (about 14 $\mu$m average diameter) and rice starch (about 14 $\mu$m average diameter) are applied to the tacky surfaces. The following results are obtained:

| Control | Rice Starch (%) | Gloss Units | Appearance |
|---|---|---|---|
| C | 0 | 35 | poor |
| D | 10 | 25 | poor |
| E | 25 | 28 | poor |
| F | 50 | 31 | poor |
| G | 75 | 34 | poor |
| H | 100 | 41 | poor |

These controls illustrate the criticality of the ratio of the carrier particles to particulate material.

### Example 20

A negative-working pre-press color proof of the surprint type is prepared as described in Example 2 wherein a positive-working photopolymer layer is laminated onto the outer surface of the four-color proof.

The four-color surprint proof having the positive-working photopolymer layer thereon is returned to the exposure device described above. Over the element with the positive-working photopolymer layer is placed a screen tint (mezzotint) with a 55 positive percent dot area derived from a Policrom® GKKK Neutral Grey Fine Grain Screen manufactured by Policrom Photo Products S.p.A. Bergamo, Italy. Vacuum is applied for about one minute and the element is exposed for about 15 seconds (dot for dot rendition). The exposed element is removed from the vacuum frame, and the polyethylene terephthalate support is removed. An admixture of particulate cellulose acetate (4 g, about 5 $\mu$m average diameter) and Surlyn®A ionomer resin beads (carrier particles) manufactured by E.I. du Pont de Nemours and Company, Wilmington, Delaware (16 g, about 25 $\mu$m average diameter) is applied to the exposed photopolymer surface by means of a fiber pad dipped into the admixture. The surface is wiped with a cotton cloth to remove excess cellulose acetate and all the carrier particles. The four-color proof has a uniform matte finish which is clean, dry and resembles a press sheet. The finish is durable, is nonblocking, and is capable of being written on with pencil, pen or crayon. The prepared proofs show no deterioration due to cracking or crazing for a period of at least three months at ambient temperature.

Example 21

Example 20 is repeated except that in place of the 55 positive percent dot area screen tint is used a 25 positive percent dot area screen tint derived from a similar screen as described in Example 20. The resultant proof exhibits the same desirable features with a lesser degree of matte.

Example 22

Example 20 is repeated except that the positive-working photopolymer element with the screen tint in place is exposed for 30 seconds in the exposure device described in Example 20. The resultant proof exhibits the same desirable features with a lesser degree of matte.

**Claims**

1. A process for modifying a tacky surface by adhering particulate material thereto which comprises
 (1) applying the particulate material to said tacky surface, and
 (2) removing excess particulate material therefrom,
characterized in that prior to application to the tacky surface the particulate material is admixed with carrier particles which are removed with the excess particulate material, the ratio in the mixture of the average particle diameter of carrier particles to that of the particulate material in the mixture being greater than 2 and the weight ratio of particulate material to carrier particles being less than 1.

2. A process according to Claim 1 characterized in that the tacky surface is present in a photopolymerizable layer.

3. A process according to Claim 1 characterized in that the tacky surface is present in an element containing nontonable image areas and tacky nonphotosensitive image areas.

4. A process according to Claim 1 characterized in that the tacky surface is a tacky adhesive layer.

5. A process according to any one of the preceding claims characterized in that the particulate material is cellulose acetate.

6. A process according to any one of the preceding claims characterized in that the carrier particles are an ionic copolymer.

7. A process according to any one of claims 2 to 6 characterized in that subsequent to application of the admixture to the tacky photopolymer surface the surface is nonimagewise exposed to actinic radiation.

8. A process according to any one of the preceding claims characterized in that the admixture of the particulate material and carrier particles contains particulate pigment material.

9. A process according to Claim 1 characterized in that the tacky surface is present as the outer layer of a surprint multicolor proof having at least two laminates bearing a colored image sequentially bonded to a support, and in that prior to application to the tacky surface of the admixture of particulate material and carrier particles the photosensitive tacky layer is exposed through a screen tint.

10. A process according to Claim 9 characterized in that the laminates, prior to exposure, comprise a photoadherent layer comprising a nontacky photohardenable material with ethylenically unsaturated or benzophenone type groups and a contiguous layer of a nonphotosensitive, tacky organic material.

11. A process according to Claim 10 characterized in that the tacky layer present as the outer layer of the proof is formed by laminating to the outer colored laminate a third photohardenable laminate comprising a contiguous layer of a nonphotosensitive, tacky organic material, a photoadherent layer of a nontacky photohardenable material with ethylenically unsaturated or benzophenone type groups, and a removable cover sheet; exposing the element nonimagewise through the cover sheet to harden the photohardenable layer; and removing the cover sheet with the exposed photoadherent layer.

12. A process according to Claim 11 characterized in that each colored laminate has been exposed through a different color separation negative and the respective photoadherent layers have been colored in a spectral region corresponding to the color separation negative used for the exposure.

13. A process according to Claim 12 characterized in that four laminates are present in the surprint multicolor proof and the laminates and colored separation negatives correspond, respectively, to yellow, magenta, cyan and black.

14. A process according to Claim 9 characterized in that the tacky layer is a photohardenable layer containing at least one free-radical initiated, chain propagating, addition polymerizable compound containing at least one terminal ethylenic group, and an addition polymerization initiator activatable by actinic radiation, and, optionally a compatible macromolecular organic polymeric binder.

15. A process according to Claim 9 characterized in that a protective sheet is present on the tacky layer during the exposure, the protective sheet being removed prior to application of the admixture of particulate material and carrier particles.

16. A process according to Claim 9 characterized in that the particulate material is cellulose acetate.

17. A process according to Claim 9 characterized in that the carrier particles are an ionic copolymer.

18. A process according to Claim 9 characterized in that the admixture of the particulate material and carrier particles contains particulate pigment material.

19. A process according to Claim 9 characterized in that the screen tint is a halftone screen tint having a tint value of 25 to 75 percent with a screen ruling of 85 to 400 lines per inch (3.35 to 15.75 lines per mm).

20. A process according to Claim 9 characterized in that the screen tint has a tint value of 25 to 75 percent with a random pattern corresponding to 85 to 400 lines per inch (3.35 to 15.75 lines per mm).

## Revendications

1. Un procédé de modification d'une surface poisseuse en y faisant adhérer une matière en particules, qui comprend

(1) l'application de la matière en particules à la surface poisseuse, et

(2) l'enlèvement de la matière en particules en excès à partir de cette surface, caractérisé en ce que, avant son application à la surface poisseuse, la matière en particules est mélangée avec des particules d'un véhicule qui sont enlevées avec la matière en particules en excès, le rapport dans le mélange du diamètre de particules moyen des particules de véhicule à celui de la matière en particules dans le mélange étant supérieur à 2 et le rapport en poids de la matière en particules aux particules de véhicule étant inférieur à 1.

2. Un procédé selon la revendication 1, caractérisé en ce que la surface poisseuse est présente dans une couche photopolymérisable.

3. Un procédé selon la revendication 1, caractérisé en ce que la surface poisseuse est présente dans un élément contenant des zones d'image non-pigmentables et des zones d'image non-photosensibles poisseuses.

4. Un procédé selon la revendication 1, caractérisé en ce que la surface poisseuse est une couche adhésive poisseuse.

5. Un procédé selon l'une quelconque des revendications précédentes, caractérisé en ce que la matière en particules est de l'acétate de cellulose.

6. Un procédé selon l'une quelconque des revendications précédentes, caractérisé en ce que les particules de véhicule sont constituées d'un copolymère ionique.

7. Un procédé selon l'une quelconque des revendications 2 à 6, caractérisé en ce que, après l'application du mélange à la surface de photopolymère poisseuse, on expose globalement la surface à une radiation actinique.

8. Un procédé selon l'une quelconque des revendications précédentes, caractérisé en ce que le mélange de matière en particules et de particules de véhicule contient une matière pigmentaire en particules.

9. Un procédé selon la revendication 1, caractérisé en ce que la surface poisseuse est présente en tant que la couche extérieure d'une épreuve multicolore de surimpression ayant au moins deux stratifiés portant une image colorée liés successivement à un support, et en ce que, avant d'appliquer à la surface poisseuse le mélange de matière en particules et de particules de véhicule, on expose la couche poisseuse photosensible à travers un benday (relief de gélatine).

10. Un procédé selon la revendication 9, caractérisé en ce que les stratifiés, avant exposition, comprennent une couche photoadhérente comprenant une matière photodurcissable non-poisseuse avec des groupes éthyléniquement insaturés ou du type de la benzophénone, et une couche contiguë d'une matière organique poisseuse, nonphotosensible.

11. Un procédé selon la revendication 10, caractérisé en ce que la couche poisseuse, présente en tant que couche extérieure de l'épreuve, est formée en stratifiant sur le stratifié coloré extérieur un troisième stratifié photodurcissable comprenant une couche contiguë d'une matière organique poisseuse non-photosensible, une couche photoadhérente d'une matière photodurcissable non-poisseuse avec des groupes éthyléniquement insaturés ou du type de la benzophénone, et une feuille de couverture éliminable; en exposant globalement l'élément à travers la feuille de couverture pour durcir la couche photodurcissable; et en enlevant la feuille de couverture avec la couche exposée photoadhérente.

12. Un procédé selon la revendication 11, caractérisé en ce que chaque stratifié coloré a été exposé à travers un négatif de sélection de couleurs différent et en ce que les couches photo-adhérentes respectives ont été colorées dans une région du spectre correspondant au négatif de sélection de couleurs utilisé pour l'exposition.

13. Un procédé selon la revendication 12, caractérisé en ce que quatre stratifiés sont présents dans l'épreuve multicolore de surimpression et les stratifiés et les négatifs de sélection colorés correspondent, respectivement, au jaune, au magenta, au cyan et au noir.

14. Un procédé selon la revendication 9, caractérisé en ce que la couche poisseuse est une couche photodurcissable contenant au moins un composé polymérisable par addition, à propagation en chaîne, initiée par des radicaux libres comportant au moins un groupe éthylénique terminal, et un initiateur de polymérisation d'addition activable par une radiation actinique, et, facultativement, un liant polymère organique macromoléculaire compatible.

15. Un procédé selon la revendication 9, caractérisé en ce qu'une couche protectrice est présente sur la couche poisseuse pendant l'exposition, cette couche protectrice étant enlevée avant l'application du mélange de matière en particules et de particules de véhicule.

16. Un procédé selon la revendication 9, caractérisé en ce que la matière en particules est de l'acétate de cellulose.

17. Un procédé selon la revendication 9, caractérisé en ce que les particules de véhicule sont constituées d'un copolymère ionique.

18. Un procédé selon la revendication 9, caractérisé en ce que le mélange de matière en particules et de particules de véhicule contient une matière pigmentaire en particules.

19. Un procédé selon la revendication 9, caractérisé en ce que le benday est un benday tramé ayant une valeur de grisé de 25 à 75% avec un lignage de trame de 3,35 à 15,75 lignes par mm.

20. Un procédé selon la revendication 9, caractérisé en ce que le benday a une valeur de grisé de 25 à 75% avec un motif aléatoire correspondant à 3,35 à 15,75 lignes par mm.

## Patentansprüche

1. Verfahren zur Modifizierung klebriger Oberflächen durch Aufkleben eines teilchenförmigen Materials, bei dem

(1) das teilchenförmige Material auf die klebrige Oberfläche aufgebracht wird und

(2) überschüssiges teilchenförmiges Material von dieser entfernt wird,

dadurch gekennzeichnet, daß vor dem Auftragen auf die klebrige Oberfläche das teilchenförmige Material mit Trägerteilchen vermischt wird, die mit dem überschüssigen teilchenförmigen Material entfernt werden, wobei das Verhältnis des mittleren Teilchendurchmessers der Trägerteilchen in der Mischung zu demjenigen des teilchenförmigen Materials in der Mischung größer als 2 ist und das Gewichtsverhältnis des teilchenförmigen Materials zu den Trägerteilchen kleinen als 1 ist.

2. Verfahren nach Anspruch 1, dadurch gekennzeichnet, daß die klebrige Oberfläche in einer photopolymerisierbaren Schicht vorliegt.

3. Verfahren nach Anspruch 1, dadurch gekennzeichnet, daß die klebrige Oberfläche in einem Element vorliegt, das nicht-tonbare Bildbereiche und klebrige, nicht-photoempfindliche Bildbereiche enthält.

4. Verfahren nach Anspruch 1, dadurch gekennzeichnet, daß die klebrige Oberfläche eine klebrige Haftschicht ist.

5. Verfahren nach irgendeinem der vorhergehenden Ansprüche, dadurch gekennzeichnet, daß das teilchenförmige Material Celluloseacetat ist.

6. Verfahren nach irgendeinem der vorhergehenden Ansprüche, dadurch gekennzeichnet, daß die Trägerteilchen ein ionisches Copolymerisat sind.

7. Verfahren nach irgendeinem der Ansprüche 2 bis 6, dadurch gekennzeichnet, daß im Anschluß an das Aufbringen der Mischung auf die klebrige Photopolymer-Oberfläche die Oberfläche nicht-bildweise aktinischer Strahlung ausgesetzt wird.

8. Verfahren nach irgendeinem der vorhergehenden Ansprüche, dadurch gekennzeichnet, daß die Mischung des teilchenförmigen Materials und der Trägerteilchen teilchenförmiges Pigmentmaterial enthält.

9. Verfahren nach Anspruch 1, dadurch gekennzeichnet, daß die klebrige Oberfläche als die äußere Schicht einer Mehrfarben-"Surprint"-Vorlage mit wenigstens zwei ein gefärbtes Bild tragenden Laminaten, die nacheinander an einen Träger gebunden sind, vorliegt und daß vor dem Aufbringen der Mischung des teilchenförmigen Materials und der Trägerteilchen auf die klebrige Oberfläche die photoempfindliche klebrige Schicht durch ein Siebkopierraster belichtet wird.

10. Verfahren nach Anspruch 9, daducrh gekennzeichnet, daß die Laminate vor der Belichtung eine Photohaftschicht aus einem nichtklebrigen lichthärtbaren Material mit ethylenisch ungesättigten Gruppen oder Gruppen vom Benzophenon-Typ und eine Berührungsschicht eines nichtphotoempfindlichen klebrigen organischen Materials enthalten.

11. Verfahren nach Anspruch 10, dadurch gekennzeichnet, daß die als äußere Schicht der Vorlage vorliegende klebrige Schicht durch Laminieren eines dritten photohärtbaren Laminats aus einer Berührungsschicht eines nicht-photoempfindlichen klebrigen organischen Materials, einer Photohaftschicht

14

aus einem nichtklebrigen lichthärtbaren Material mit ethylenisch ungesättigten Gruppen oder Gruppen vom Benzophenon-Typ und einer entfernbaren Deckfolie auf das äußere gefärbte Laminat, nicht-bildweises Belichten des Elements durch die Deckfolie hindurch zur Härtung der lichthärtbaren Schicht und Entfernen der Deckfolie mit der belichteten Photohaftschicht gebildet wird.

12. Verfahren nach Anspruch 11, dadurch gekennzeichnet, daß jedes gefärbte Laminat durch ein anderes Farbauszugsnegativ belichtet worden ist und die betreffenden Photohaftschichten in einem Spektralbereich gefärbt sind, der dem für die Belichtung verwendeten Farbauszugsnegativ entspricht.

13. Verfahren nach Anspruch 12, dadurch gekennzeichnet, daß vier Laminate in der Mehrfarben-"Surprint"-Vorlage vorliegen und die Laminate und Farbauszugsnegative Gelb, Purpurrot, Cyanblau und Schwarz entsprechen.

14. Verfahren nach Anspruch 9, dadurch gekennzeichnet, daß die kelbrige Schicht eine lichthärtbare Schicht ist, die wenigstens eine durch freie Radikale initiierte, kettenverlängernde additionspolymerisierbare Verbindung mit wenigstens einer endständigen ethylenischen Gruppe sowie einen durch aktinische Strahlung aktivierbaren Additionspolymerisations-Initiator und gegebenenfalls ein verträgliches, makromolekulares organisches Bindemittel enthält.

15. Verfahren nach Anspruch 9, dadurch gekennzeichnet, daß während der Belichtung eine Schutzfolie auf der klebrigen Schicht vorhanden ist, wobei die Schutzfolie vor dem Aufbringen der Mischung aus dem teilchenförmigen Material und den Trägerteilchen entfernt wird.

16. Verfahren nach Anspruch 9, dadurch gekennzeichnet, daß das teilchenförmige Material Celluloseacetat ist.

17. Verfahren nach Anspruch 9, dadurch gekennzeichnet, daß die Trägerteilchen ein ionisches Copolymerisat sind.

18. Verfahren nach Anspruch 9, dadurch gekennzeichnet, daß die Mischung des teilchenförmigen Materialsund der Trägerteilchen teilchenförmiges Pigmentmaterial enthält.

19. Verfahren nach Anspruch 9, dadurch gekennzeichnet, daß das Siebkopierraster ein Halbton-Siebkopierraster ist, das eine Tönungswert von 25 bis 75% mit einem Siebgitter von 85 bis 400 Linien/Zoll (3,35 bis 15.75 Linien/mm) aufweist.

20. Verfahren nach Anspruch 9, dadurch gekennzeichnet, daß das Siebkopierraster einen Tönungswert von 25 bis 75% mit einem Zufallsmuster, das 85 bis 400 Linien/Zoll (3,35 bis 15,75 Linien/mm) entspricht, aufweist.